# EUROPEAN PATENT SPECIFICATION

(11) **EP 1 900 801 B1**
(45) Date of publication and mention of the grant of the patent: **16.06.2010**
(21) Application number: 07017582.3
(22) Date of filing: 07.09.2007
(51) Int. Cl.: C11D 7/28, C11D 7/50, H01L 21/306, C23G 5/032, C11D 11/00

(54) **Substrate water-removing agent, and water-removing method and drying method employing same**
Mittel zur Entfernung von Wasser aus einem Substrat, Verfahren zur Wasserentfernung und Trocknungsverfahren damit
Agent d'élimination d'eau d'un substrat et procédé d'élimination d'eau et procédé de séchage l'utilisant

(30) Priority: 14.09.2006 JP 2006248955
(43) Date of publication of application: 19.03.2008
(73) Proprietor: FUJIFILM Corporation, Minato-ku Tokyo (JP)
(72) Inventor: Seki, Hiroyuki, Haibara-gun Shizuoka (JP)
(74) Representative: HOFFMANN EITLE

(56) References cited:
- EP-A- 0 389 087
- DATABASE WPI Week 199510 Derwent Publications Ltd., London, GB; AN 1995-070578 XP002459894 & JP 06 346096 A (AGENCY OF IND SCI & TECHNOLOGY) 20 December 1994 (1994-12-20)

## Description

This invention relates to a water-removing method for a processed substrate such as a semiconductor substrate or a liquid crystal substrate (hereinafter, also simply called a 'substrate').

In general, a semiconductor production process includes a drying step in which a washed substrate is dried. As a drying method for carrying out this drying step, there is a method in which a substrate is rotated so as to throw off water droplets on the substrate by means of the resulting centrifugal force (ref. Patent Publications 1 and 2), and a method is described in which a substrate is placed in an atmosphere of isopropyl alcohol vapor and water is removed by replacing water on the substrate with isopropanol. Furthermore, instead of isopropanol, proposals related to various types of fluorine-containing alcohols or fluorine-containing ethers have been made (ref. Patent Publications 3 to 11).
(Patent Publication 1) JP-A-1-140728 (JP-A denotes a Japanese unexamined patent application publication)
(Patent Publication 2) JP-A-6-310486
(Patent Publication 3) JP-A-2-203529
(Patent Publication 4) JP-A-3-93899
(Patent Publication 5) JP-A-3-106024
(Patent Publication 6) JP-A-6-346095
(Patent Publication 7) JP-A-6-346096
(Patent Publication 8) JP-A-7-62394
(Patent Publication 9) JP-A-7-70599
(Patent Publication 10) JP-A-2000-38673
(Patent Publication 11) JP-A-2005-171147

However, these conventional techniques have the problems, which have not been fully solved, that drying takes time and marks are caused by water that remains. Furthermore, in recent years, there has been a requirement to form more complicated structures on the surface of a substrate in order to improve semiconductor performance and, in particular, it has become necessary to form a high-aspect-ratio columnar (or cylindrical) and/or high-aspect-ratio hole-shaped structure having a height (or depth)/short side (or diameter) aspect ratio of at least 50. When conventional techniques are applied to such a substrate, there are the problems that the columnar or cylindrical structure collapses or breaks during drying, the ability to wash the interior of the hole-shaped structure is poor, and watermarks or incomplete washing occur.

Therefore, the present invention has been accomplished in order to solve the above-mentioned problems, and it is an object thereof to remove water from a substrate and carry out drying efficiently without breaking or contaminating the substrate.

According to a first aspect, the present invention provides a water-removing method comprising the steps of:
(i) bringing a substrate bearing a columnar pattern having a height/diameter aspect ratio of at least 50 and/or a hole-shaped pattern having a depth/diameter aspect ratio of at least 50 into contact with water or an aqueous rinsing liquid; and
(ii) bringing the substrate into contact with a water-removing agent comprising 1,1,1,3,3,3-hexafluoro-2-propanol.

Preferably, the columns of the columnar pattern or the holes of the hole-shaped pattern have a diameter of 10 to 500 nm.

Preferably, the columnar pattern structure and/or the hole-shaped pattern structure is rectangular or circular.

Step (ii) of the above method is preferably selected from:
(a) immersing the substrate in the water-removing agent,
(b) spraying the substrate with the water-removing agent, and
(c) placing the substrate in an atmosphere of the vapour of the water-removing agent.

Preferably, the substrate is formed from a metal, a metal oxide or a metal nitride.

Preferably, the method further comprises the step of drying the substrate after step (ii).

Preferably, the water-removing agent either consists of 1,1,1,3,3,3-hexafluoro-2-propanol or is a mixture comprising:
at least 10% by weight of 1,1,1,3,3,3-hexafluoro-2-propanol, and
another compound that is miscible with 1,1,1,3,3,3-hexafluoro-2-propanol at room temperature.

Preferably, the water-removing agent comprises 10 to 100 wt.% of 1,1,1,3,3,3-hexafluoro-2-propanol and 90 to 0 wt.% of isopropanol.

The present invention is explained in detail below.

1,1,1,3,3,3-Hexafluoro-2-propanol, which is used in the present invention, may be used on its own or may be used in a combination with another compound that is miscible therewith. The compound used in combination is preferably one such that the compound and 1,1,1,3, 3,3-hexafluoro-2-propanol are completely soluble in each other at room temperature; preferred examples include an alcohol containing no fluorine atom (e.g., methyl alcohol, ethyl alcohol, propyl alcohol, isopropanol, butyl alcohol), a fluorine-containing ether (e.g., methyl nonafluoroisobutyl ether, methyl nonafluorobutyl ether, trifluoroethyl methyl ether, trifluoroethyl difluoromethyl ether, pentafluoropropyl methyl ether, pentafluoropropyl difluoromethyl ether, pentafluoropropyl tetrafluoroethyl ether, trifluoroethyl methyl ether, tetrafluoroethyl ethyl ether, tetrafluoroethyl trifluoroethyl ether, tetrafluoropropyl difluoromethyl ether, tetrafluoroethyl tetrafluoropropyl ether, hexafluoroisopropyl methyl ether, 1,1,3,3,3-pentafluoro-2-(trifluoromethyl)-propyl methyl ether, hexafluoropropyl ethyl ether, hexafluoropropyl methyl ether, hexafluorobutyl difluoromethyl ether), a fluorine-based carbon compound (e.g., perfluoropentane, perfluorohexane, perfluoroheptane, etc.), and water, an alcohol containing no fluorine atom is particularly preferable, and isopropanol is most preferable. When 1,1,1,3,3,3-hexafluoro-2-propanol is used in a combination, the content thereof is preferably at least 10 wt % when used for removing water, and particularly preferably at least 50 wt %. The water-removing treatment may be carried out a plurality of times using the same conditions with respect to the content and/or different conditions. The water-removing agent for substrate washing may be supplied as a concentrate and diluted when it is used.

It is surmised that, among various types of fluorine-containing compounds and fluorine-containing ether compounds, the compound of the present invention is perhaps preferable since it has an appropriate relationship between solubility in water and surface tension.

A method for bringing a processed substrate into contact with the water-removing agent used in the present invention so as to remove water is not particularly limited, and the processed substrate may be immersed in the water-removing agent, the processed substrate may be sprayed with the water-removing agent, or the processed substrate may be placed in an atmosphere of a vapor of the water-removing agent (vapor treatment).

Furthermore, when the water-removing agent of the present invention is used, a physical force such as a rotary motion, ultrasonic vibration or brushing may be applied to a processed substrate. These physical operations may be carried out on their own or in combination.

The contact treatment with the water-removing agent is preferably carried out for 1 to 600 sec., and particularly preferably 10 to 300 sec. With regard to the temperature for the contact treatment with the water-removing agent, when immersion is involved, the temperature of the water-removing agent is preferably from 5°C to less than the boiling point of the liquid, and particularly preferably from 15°C to less than the boiling point. In the case of the vapor treatment (treatment under an atmosphere of a vapor), the temperature is preferably above the vicinity of the boiling point and is particularly preferably at 30-200°C, and the vapor treatment may be carried out immediately after immersion in the water-removing agent is carried out.

The amount of water-removing agent used in the water-removing method of the present invention is preferably 0.01 to 50 mL/min per cm² of the processed substrate in the case of spraying or the vapor treatment, and particularly preferably 0.1 to 10 mL/min. Moreover, when the processed substrate is immersed, since a plurality of processed substrates are immersed in the same liquid, the amount of water-removing agent used is preferably 0.05 to 100 mL per cm² of the processed substrate, and particularly preferably 0.5 to 50 mL.

The processed substrate used in the water-removing method of the present invention has on the surface of the substrate a columnar pattern structure and/or a hole-shaped pattern structure. Said columnar pattern structure and/or hole-shaped pattern structure may be rectangular or circular. They may be a quadrangular prism or cylinder having a cavity in a middle section thereof, or a rectangular hole or cylindrical hole having a pillar in a middle section thereof. The water-removing method of the present invention is applied to a processed substrate having thereon a cylindrical pattern structure and/or a hole-shaped pattern structure. Furthermore, the present invention is effective for a columnar structure and/or hole-shaped structure having a high aspect ratio in terms of the height (or depth) diameter ratio of at last 50. An aspect ratio of at least 70 is particularly preferable.

It is particularly preferred that the columns of the columnar pattern or the holes of the hole-shaped pattern have a diameter of 10 to 500 nm.

Examples of the processed substrate for which the present invention can be applied include those in a process for producing a 200 or 300 mm semiconductor wafer or a process for producing a micromachine.

Examples of the processed substrate include a semiconductor silicon wafer, an SOI (silicon-on-insulator) wafer, a compound semiconductor sapphire substrate used in a semiconductor laser, etc. Among them, a silicon substrate is most preferable. The surface of the pattern may constitute hemispherical Si in order to gain surface area. Furthermore, as the material constituting the pattern, various types of metal such as tantalum or zirconium, titanium, ruthenium, a metal oxide, a metal nitride, etc. may be used.

In the present invention, the pattern surface is preferably a metal and/or a metal oxide.

The pattern formed on the processed substrate of the present invention is preferably formed from an organic component such as a resist, and a metal, a metal oxide, or a metal nitride, such as Si or SiO_{2,} and the present invention exhibits a particularly excellent effect for a processed substrate having a pattern formed from a metal, a metal oxide, or a metal nitride.

As an etching liquid used for forming the pattern of a processed substrate used in the present invention, a buffered hydrofluoric acid (BHF) is widely used, and specifically it is a mixed liquid of hydrofluoric acid and ammonium fluoride, and may preferably contain a surfactant, depending on the situation.

Normally, after this etching treatment, a rinsing treatment (water washing treatment) is carried out, and following this the treatment with the water-removing agent of the present invention is carried out. In the present invention, it is preferable for a surfactant or a water-soluble solvent to be present in the rinsing treatment between the etching treatment and the treatment with the water-removing agent.

As the surfactant in the rinsing liquid, various types of anionic surfactant, cationic surfactant, nonionic surfactant, or betaine surfactant may be used, but nonionic surfactants in particular are preferable from the viewpoint of contaminant residue, and among them nonionic surfactants having 5 to 15 carbons and a hydroxyl group are preferable. Specific compound examples thereof include 3,5-dimethyl-1-hexyn-3-ol, but they are not limited thereby. As the water-soluble solvent, various types of solvents may be present, such as alcohols, ethers, aldehydes, glycols, and amines, and among these alcohols (e.g., methyl alcohol, ethyl alcohol, propyl alcohol, isopropanol, butyl alcohol, 1,1,1, 3,3,3-hexafluoro-2-propanol, 1,1,1,2,2,3,3,4,4-nonafluorohexanol, 1,1,1, 3,3,4,4,4-octafluorobutan-2-ol, 2-trifluoromethyl-1,1,1,3,3,3-hexafluoropropan-2-ol, 2-trifluoromethyl-1,1,1-trifluoropropan-2-ol, 2,2,2-trifluoroethanol, 2,2,3,3-tetrafluoropropanol and 2,2,3,3,3-pentafluoropropanol) are preferable, and isopropanol is most preferable.

In accordance with the present invention, the removal of water from a processed substrate is excellent, and a processed substrate that is free from watermarks after drying can be obtained.

### EXAMPLES

### Example 1

Silicon wafers (6 x 6 cm cut product) were treated with a buffered hydrofluoric acid solution (LAL1000, manufactured by Stella Chemifa Corporation: 200 mL), then washed with water (1,000 mL), and subsequently immersed in the water-removing agents below (200 mL) for 5 minutes. The silicon wafers were then taken out and dried, and the condition of a pattern of the dried wafer and the level of contamination were examined by scanning tunneling microscope (S4800, manufactured by Hitachi High-Technologies Corporation). The pattern formed was a zirconium-containing cylindrical pattern having an aspect ratio described in Table 1. The results thus obtained are given in Table 1.
Water-removing agent-1:
   1,1,1,3,3,3-hexafluoro-2-propanol (ratio by weight 100%)
Water-removing agent-2:
   1,1,1,3,3,3-hexafluoro-2-propanol (ratio by weight 80%)
   isopropanol (ratio by weight 20%)
Water-removing agent-3:
   1,1,1,3,3,3-hexafluoro-2-propanol (ratio by weight 50%)
   isopropanol (ratio by weight 50%)
Water-removing agent-4:
   1,1,1,3,3,3-hexafluoro-2-propanol (ratio by weight 10%)
   isopropanol (ratio by weight 90%)
Water-removing agent-5:
   isopropanol (ratio by weight 100%)
Water-removing agent-6:
   1,1,1,2,2,3,3,4,4-nonafluorohexane (ratio by weight 100%)
Water-removing agent-7:
   1,1,1,3,3,4,4,4-octafluorobutan-2-ol (ratio by weight 100%)
Water-removing agent-8:
   2-trifluoromethyl-1,1,1,3,3,3-hexafluoropropan-2-ol (ratio by weight 100%)
Water-removing agent-9:
   2-trifluoromethyl-1,1,1-trifluoropropan-2-ol (ratio by weight 100%)
Water-removing agent-10:
   1,1-dichloro-2,2,3,3,3-pentafluoropropane (ratio by weight 100%)
Water-removing agent-11:
   1,3-dichloro-1,2,2,3,3-pentafluoropropane (ratio by weight 100%)
Water-removing agent-12:
   2,2,2-trifluoroethanol (ratio by weight 100%)
Water-removing agent-13:
   2,2,3,3-tetrafluoropropanol (ratio by weight 100%)
Water-removing agent-14:
   2,2,3,3,3-pentafluoropropanol (ratio by weight 100%)
Water-removing agent-15:
   1,1,2,2-tetrafluoroethyl-2,2,2-trifluoroethyl ether (ratio by weight 100%)

**(Table 1)**

| Level | Water-removing agent | Pattern shape | Occurrence of pattern collapse | Contamination | Remarks |
|---|---|---|---|---|---|
| Level-1 | Water-removing agent-1 | A | Good | Good | This invention |
| Level-2 | Water-removing agent-2 | A | Good | Good | This invention |
| Level-3 | Water-removing agent-3 | A | Good | Good | This invention |
| Level-4 | Water-removing agent-4 | A | Good | Good | This invention |
| Level-5 | Water-removing agent-1 | B | Good | Good | This invention |
| Level-7 | Water-removing agent-1 | D | Good | Good | This invention |
| Level-8 | Water-removing agent-1 | E | Good | Good | This invention |
| Level-9 | Water-removing agent-1 | F | Good | Good | This invention |
| Level-10 | Water-removing agent-5 | A | Poor | Good | Comparative example |
| Level-11 | Water-removing agent-6 | F | Fair | Fair | Comparative example |
| Level-12 | Water-removing agent-7 | A | Poor | Poor | Comparative example |
| Level-13 | Water-removing agent-8 | A | Poor | Poor | Comparative example |
| Level-14 | Water-removing agent-9 | A | Poor | Good | Comparative example |
| Level-15 | Water-removing agent-10 | A | Poor | Poor | Comparative example |
| Level-16 | Water-removing agent-11 | A | Poor | Poor | Comparative example |
| Level-17 | Water-removing agent-12 | A | Poor | Good | Comparative example |
| Level-18 | Water-removing agent-13 | A | Poor | Good | Comparative example |
| Level-19 | Water-removing agent-14 | A | Poor | Fair | Comparative example |
| Level-20 | Water-removing agent-15 | A | Poor | Poor | Comparative example |

| | | | | | |
|---|---|---|---|---|---|
| Pattern shape A: aspect ratio 50 = (height) 2,500 nm/(diameter) 50 nm B: aspect ratio 100 = (height) 5,000 nm/(diameter) 50 nm D: aspect ratio 50 = (height) 1,000 nm/(diameter) 20 nm E: aspect ratio 50 = (height) 5,000 nm/(diameter) 100 nm F: aspect ratio 50 = (height) 2,5000 nm/(diameter) 500 nm | | | | | |

### Evaluation criteria for occurrence of pattern collapse

Good: from the results of examination by scanning tunneling microscope, there was hardly any disturbance of the pattern spacing.
Fair: from the results of examination by scanning tunneling microscope, there was about 10% disturbance of the pattern spacing.
Poor: from the results of examination by scanning tunneling microscope, more than half of the pattern spacing was disturbed.

### Evaluation criteria for contamination

Good: from the results of examination by scanning tunneling microscope, there was hardly any foreign matter attached.
Fair: from the results of examination by scanning tunneling microscope, there was a slight degree of attachment of foreign matter.
Poor: from the results of examination by scanning tunneling microscope, the attachment of foreign matter was easily observed.

### Example 2

A silicon wafer (diameter 300 mm) having the pattern shape D in Example 1 was treated with a buffered hydrofluoric acid solution (LAL500, manufactured by Stella Chemifa Corporation), then washed with water, subsequently subjected to a vapor treatment (treatment under an atmosphere of a vapor) with the water-removing agent below (water-removing agent 1 described in Example 1) for 5 minutes, and dried (FC-3100 equipment: manufactured by Dainippon Screen Manufacturing Co., Ltd.), and the condition of a pattern of the dried wafer and the level of contamination were examined by scanning tunneling microscope (S4800, manufactured by Hitachi High-Technologies Corporation). The results were as good as in Example 1, without pattern collapse or contamination.

### Example 3

Silicon wafers (6 x 6 cm cut product) were treated with a buffered hydrofluoric acid solution (LAL1000, manufactured by Stella Chemifa Corporation: 200 mL), then washed with a water-isopropanol mixed solution (a ratio by weight of water to isopropanol = 4:1), and subsequently immersed in the same water-removing agents (200 mL) as in Example 1 for 5 minutes. The silicon wafers were then taken out and dried, and the condition of a pattern of the dried wafer and the level of contamination were examined by scanning tunneling microscope (S4800, manufactured by Hitachi High-Technologies Corporation). The pattern formed was a circular hole having an aspect ratio described in Table 2. The results thus obtained are given in Table 2.

**(Table 2)**

| Level | Water-removing agent | Pattern shape | Watermarks in the vicinity of hole | Foreign matter in vicinity of hole | Remarks |
|---|---|---|---|---|---|
| Level-1 | Water-removing agent-1 | A | Good | Good | This invention |
| Level-2 | Water-removing agent-2 | A | Good | Good | This invention |
| Level-3 | Water-removing agent-3 | A | Good | Good | This invention |
| Level-4 | Water-removing agent-4 | A | Good | Good | This invention |
| Level-5 | Water-removing agent-1 | B | Good | Good | This invention |
| Level-7 | Water-removing agent-1 | D | Good | Good | This invention |
| Level-8 | Water-removing agent-1 | E | Good | Good | This invention |
| Level-9 | Water-removing agent-1 | F | Good | Good | This invention |
| Level-10 | Water-removing agent-5 | A | Poor | Poor | Comparative example |
| Level-11 | Water-removing agent-6 | F | Poor | Poor | Comparative example |
| Level-12 | Water-removing agent-7 | A | Poor | Poor | Comparative example |
| Level-13 | Water-removing agent-8 | A | Poor | Fair | Comparative example |
| Level-14 | Water-removing agent-9 | A | Fair | Poor | Comparative example |
| Level-15 | Water-removing agent-10 | A | Poor | Poor | Comparative example |
| Level-16 | Water-removing agent-11 | A | Poor | Fair | Comparative example |
| Level-17 | Water-removing agent-12 | A | Poor | Good | Comparative example |
| Level-18 | Water-removing agent-13 | A | Fair | Good | Comparative example |
| Level-19 | Water-removing agent-14 | A | Poor | Fair | Comparative example |
| Level-20 | Water-removing agent-15 | A | Poor | Poor | Comparative example |

| | | | | | |
|---|---|---|---|---|---|
| Pattern shape A: aspect ratio 50 = (depth) 2,500 nm/(inner diameter) 50 nm B: aspect ratio 100 = (depth) 5,000 nm/(inner diameter) 50 nm D: aspect ratio 50 = (depth) 1,000 nm/(inner diameter) 20 nm E: aspect ratio 50 = (depth) 5,000 nm/(inner diameter) 100 nm F: aspect ratio 50 = (depth) 25,000 nm/(inner diameter) 500 nm | | | | | |

### Evaluation criteria for occurrence of watermarks

Good: from the results of examination by scanning tunneling microscope, hardly any watermarks occurred.
Fair: from the results of examination by scanning tunneling microscope, a few watermarks could be observed.
Poor: from the results of examination by scanning tunneling microscope, the occurrence of watermarks was easily observed.

### Evaluation criteria for contamination

Good: from the results of examination by scanning tunneling microscope, there was hardly any foreign matter attached.
Fair: from the results of examination by scanning tunneling microscope, there was a slight degree of attachment of foreign matter.
Poor: from the results of examination by scanning tunneling microscope, the attachment of foreign matter was easily observed.

### Example 4

Silicon wafers (6 x 6 cm cut product) having the pattern shape C in Example 2 were treated under a rotary motion (100 rpm) with a buffered hydrofluoric acid solution (LAL1000, manufactured by Stella Chemifa Corporation: 200 mL), then washed with an aqueous solution comprising 3,5-dimethyl-1-hexyne-3-01 (1 wt. %), and subsequently blown for 3 minutes by a vapor formed by heating the water-removing agent 1 (described in Example 1). The silicon wafers were then taken out and dried, and the condition of a pattern of the dried wafer and the level of contamination were examined by scanning tunneling microscope (S4800, manufactured by Hitachi High-Technologies Corporation). The results were as good as in Example 2 without watermarks or attachment of foreign matter near a circular hole.

## Claims

1. A water-removing method comprising the steps of:
(i) bringing a substrate bearing a columnar pattern having a height/diameter aspect ratio of at least 50 and/or a hole-shaped pattern having a depth/diameter aspect ratio of at least 50 into contact with water or an aqueous rinsing liquid; and
(ii) bringing the substrate into contact with a water-removing agent comprising 1,1,1,3,3,3-hexafluoro-2-propanol.

2. A water-removing method according to Claim 1, wherein the columns of the columnar pattern or the holes of the hole-shaped pattern have a diameter of 10 to 500 nm.

3. A water-removing method according to Claim 1 or Claim 2, wherein the columnar pattern structure and/or the hole-shaped pattern structure is rectangular or circular.

4. A water-removing method according to any preceding claim, wherein step (ii) is selected from:
(a) immersing the substrate in the water-removing agent,
(b) spraying the substrate with the water-removing agent, and
(c) placing the substrate in an atmosphere of the vapour of the water-removing agent.

5. A water-removing method according to any preceding claim, wherein the substrate is formed from a metal, a metal oxide or a metal nitride.

6. A water-removing method according to any preceding claim, further comprising drying the substrate after step (ii).

7. A water-removing method according to any preceding claim, wherein the water-removing agent either consists of 1,1,1,3,3,3-hexafluoro-2-propanol or is a mixture comprising:
at least 10% by weight of 1,1,1,3,3,3-hexafluoro-2-propanol, and
another compound that is miscible with 1,1,1,3,3,3-hexafluoro-2-propanol at room temperature.

8. A water-removing method according to Claim 7, wherein the water-removing agent comprises 10 to 100 wt.% of 1,1,1,3,3,3-hexafluoro-2-propanol and 90 to 0 wt.% of isopropanol.

9. A water-removing method according to Claim 1, wherein the aqueous rinsing liquid comprises a surfactant.

10. A water-removing method according to Claim 9, wherein the surfactant is a nonionic surfactant having 5 to 15 carbon atoms and a hydroxyl group.

11. A water-removing method according to Claim 10, wherein the surfactant is 3,5-dimethyl-1-hexyn-3-ol.

12. A water-removing method according to Claim 1, wherein the aqueous rinsing liquid comprises a water-soluble solvent.

13. A water-removing method according to Claim 12, wherein the water-soluble solvent is an alcohol, ether, aldehyde, glycol or amine.

14. A water-removing method according to Claim 13, wherein the alcohol is isopropanol.

## Patentansprüche

1. Verfahren zum Entfernen von Wasser, umfassend die Schritte:
(i) In-Kontakt-Bringen eines Substrats, das ein säulenartiges Muster mit einem Höhe/DurchmesserVerhältnis von mindestens 50 und/oder ein lochförmiges Muster mit einem Tiefe/DurchmesserVerhältnis von mindestens 50 aufweist, mit Wasser oder einer wässrigen Spülflüssigkeit; und
(ii) In-Kontakt-Bringen des Substrats mit einem Wasser-entfernenden Mittel, das 1,1,1,3,3,3-Hexafluor-2-propanol umfasst.

2. Verfahren zum Entfernen von Wasser gemäss Anspruch 1, worin die Säulen des säulenartigen Musters oder die Löcher des lochförmigen Musters einen Durchmesser von 10 bis 500 nm aufweisen.

3. Verfahren zum Entfernen von Wasser gemäss Anspruch 1 oder Anspruch 2, worin die säulenartige Musterstruktur und/oder die lochförmige Musterstruktur rechteckig oder kreisförmig ist.

4. Verfahren zum Entfernen von Wasser gemäss irgendeinem der vorhergehenden Ansprüche, worin Schritt (ii) ausgewählt ist aus:
(a) Eintauchen des Substrats in das Wasser-entfernende Mittel,
(b) Besprühen des Substrats mit dem Wasser-entfernenden Mittel und
(c) Plazieren des Substrats in einer Dampfatmosphäre des Wasser-entfernenden Mittels.

5. Verfahren zum Entfernen von Wasser gemäss irgendeinem der vorhergehenden Ansprüche, worin das Substrat aus einem Metall, einem Metalloxid oder einem Metallnitrid gebildet ist.

6. Verfahren zum Entfernen von Wasser gemäss irgendeinem der vorhergehenden Ansprüche, ferner umfassend das Trocknen des Substrats nach Schritt (ii).

7. Verfahren zum Entfernen von Wasser gemäss irgendeinem der vorhergehenden Ansprüche, worin das Wasser-entfernende Mittel entweder aus 1,1,1,3,3,3-Hexafluor-2-propanol besteht oder eine Mischung ist, die umfasst:
mindestens 10 Gew.% 1,1,1,3,3,3-Hexafluor-2-propanol und
eine andere Verbindung, die bei Raumtemperatur mit 1,1,1,3,3,3-Hexafluor-2-propanol mischbar ist.

8. Verfahren zum Entfernen von Wasser gemäss Anspruch 7, worin das Wasser-entfernende Mittel 10 bis 100 Gew.% 1,1,1,3,3,3-Hexafluor-2-propanol und 90 bis 0 Gew.% Isopropanol umfasst.

9. Verfahren zum Entfernen von Wasser gemäss Anspruch 1, worin die wässrige Spülflüssigkeit ein Tensid umfasst.

10. Verfahren zum Entfernen von Wasser gemäss Anspruch 9, worin das Tensid ein nicht-ionisches Tensid mit 5 bis 15 Kohlenstoffatomen und einer Hydroxylgruppe ist.

11. Verfahren zum Entfernen von Wasser gemäss Anspruch 10, worin das Tensid 3,5-Dimethyl-1-hexin-3-ol ist.

12. Verfahren zum Entfernen von Wasser gemäss Anspruch 1, worin die wässrige Spülflüssigkeit ein wasserlösliches Lösungsmittel umfasst.

13. Verfahren zum Entfernen von Wasser gemäss Anspruch 12, worin das wasserlösliche Lösungsmittel ein Alkohol, Ether, Aldehyd, Glykol oder Amin ist.

14. Verfahren zum Entfernen von Wasser gemäss Anspruch 13, worin der Alkohol Isopropanol ist.

## Revendications

1. Procédé d'élimination d'eau comprenant les étapes consistant à :
(i) mettre un substrat portant un motif en colonnes présentant un indice de forme hauteur/diamètre d'au moins 50 et/ou un motif en forme de trous présentant un indice de forme profondeur/diamètre d'au moins 50, en contact avec de l'eau ou un liquide de rinçage aqueux, et
(ii) amener le substrat en contact avec un agent d'élimination d'eau comprenant du 1,1,1,3,3,3-hexafluoro-2-propanol.

2. Procédé d'élimination d'eau selon la revendication 1, dans lequel les colonnes du motif en colonnes ou les trous du motif en forme de trous ont un diamètre de 10 à 500 nm.

3. Procédé d'élimination d'eau selon la revendication 1 ou la revendication 2, dans lequel la structure du motif en colonnes et/ou la structure du motif en forme de trous est rectangulaire ou circulaire.

4. Procédé d'élimination d'eau selon l'une quelconque des revendications précédentes, dans lequel l'étape (ii) est choisie parme :
(a) immersion du substrat dans l'agent d'élimination d'eau,
(b) pulvérisation du substrat avec l'agent d'élimination d'eau, et
(c) placement du substrat dans une atmosphère de la vapeur de l'agent d'élimination d'eau.

5. Procédé d'élimination d'eau selon l'une quelconque des revendications précédentes, dans lequel le substrat est formé d'un métal, d'un oxyde métallique ou d'un nitrure métallique.

6. Procédé d'élimination d'eau selon l'une quelconque des revendications précédentes, comprenant de plus le séchage du substrat après l'étape (ii).

7. Procédé d'élimination d'eau selon l'une quelconque des revendications précédentes, dans lequel l'agent d'élimination d'eau se compose soit de 1,1,1,3,3,3-hexafluoro-2-propanol, soit d'un mélange comprenant :
au moins 10% en poids de 1,1,1,3,3,3-hexafluoro-2-propanol, et
un autre composé qui est miscible avec le 1,1,1,3,3,3-hexafluoro-2-propanol à la température ambiante.

8. Procédé d'élimination d'eau selon la revendication 7, dans lequel l'agent d'élimination d'eau comprend 10 à 100% en poids de 1,1,1,3,3,3-hexafluoro-2-propanol et 90 à 0% en poids d'isopropanol.

9. Procédé d'élimination d'eau selon la revendication 1, dans lequel le liquide de rinçage aqueux comprend un agent tensioactif.

10. Procédé d'élimination d'eau selon la revendication 9, dans lequel l'agent tensioactif est un agent tensioactif non ionique comptant 5 à 15 atomes de carbone et un groupement hydroxyle.

11. Procédé d'élimination d'eau selon la revendication 10, dans lequel l'agent tensioactif est le 3,5-diméthyl-1-hexyn-3-ol.

12. Procédé d'élimination d'eau selon la revendication 1, dans lequel le liquide de rinçage aqueux comprend un solvant hydrosoluble.

13. Procédé d'élimination d'eau selon la revendication 12, dans lequel le solvant hydrosoluble est un alcool, éther, aldéhyde, glycol ou amine.

14. Procédé d'élimination d'eau selon la revendication 13, dans lequel l'alcool est l'isopropanol.
